# EUROPEAN PATENT SPECIFICATION

(11) **EP 3 227 922 B1**
(45) Date of publication and mention of the grant of the patent: **27.11.2019**
(21) Application number: 15865372.5
(22) Date of filing: 03.12.2015
(51) Int. Cl.: H01L 27/146

(54) **IMAGING SYSTEM FOR SIMULTANEOUS IMAGING AND ENERGY HARVESTING**
BILDGEBUNGSSYSTEM ZUR GLEICHZEITIGEN BILDGEBUNG UND ENERGIEGEWINNUNG
SYSTÈME D'IMAGERIE POUR L'IMAGERIE ET LA RÉCUPÉRATION D'ÉNERGIE SIMULTANÉES

(30) Priority: 03.12.2014 US 201462086737 P; 03.12.2014 US 201462086733 P; 03.12.2014 US 201462086735 P
(43) Date of publication of application: 11.10.2017
(73) Proprietor: Robert Bosch GmbH, 70442 Stuttgart (DE)
(72) Inventor: LAJEVARDI, Pedram, Menlo Park, CA 94025 (US); SHAH, Nishit, Stanford, CA 94305 (US); LANG, Christoph, Sunnyvale, CA 94087 (US)
(86) International application number: PCT/US2015/063744
(87) International publication number: WO 2016/090144

(56) References cited:
- FR-A1- 2 997 596
- KR-A- 20100 080 173
- US-A1- 2010 219 789
- US-A1- 2010 270 459
- US-A1- 2012 074 299
- US-A1- 2012 319 225
- US-A1- 2014 263 951

## Description

### CLAIM OF PRIORITY

This application claims priority to U.S. Provisional Application No. 62/086,735, which is entitled "Imaging System For Simultaneous Imaging And Energy Harvesting," and was filed on December 3, 2014. This application also claims priority to U.S. Provisional Application No. 62/086,737, which is entitled "Pixel Structure for Energy Harvesting and Image Sensing," and was filed on December 3, 2014. This application also claims priority to U.S. Provisional Application No. 62/086,733, which is entitled "Pixel Structure for Energy Harvesting and Image Sensing," and was filed on December 3, 2014.

### FIELD

This disclosure relates generally to the field of photoelectric devices and, more specifically, to semiconductor devices that are configured for both image generation and generation of electricity in response to being exposed to light.

### BACKGROUND

Semiconductors in general, and complementary silicon metal oxide (CMOS) semiconductors in particular, are used in a wide range of applications including use as image sensors in digital cameras and as photovoltaic devices that generate electricity from sun light and other light sources. Some cameras, such as battery-powered surveillance cameras, have high energy consumption and may have a limited battery life. Some existing cameras incorporate separate photovoltaic devices that generate energy from sunlight or other light sources while also using a CMOS sensor as an image detector. However, these cameras required two different types of semiconductor devices that increase the cost, complexity, and size of the cameras.

Recent teachings in the art suggest harvesting energy CMOS image sensors that have two different operating modes or CMOS sensors that include a fixed array of sensing elements and photovoltaic energy collection elements. In the sensor embodiments that include two different operating modes, a CMOS imaging chip switches between operating modes where all of the elements in the sensor operate as either image sensing elements or as energy harvesting elements. The imaging device is switched between the imaging and energy collection modes at different times. While the CMOS sensor has lower efficiency at harvesting solar energy than a dedicated solar cell, the advantage of this approach is to use the CMOS sensor as an energy harvesting element in the camera when camera is not being used to generate images. In the fixed-array sensors, some of the elements in the CMOS sensor detect light and generate electrical signals to produce a digital image from the detected light, while other elements in the CMOS sensor are photovoltaic elements generate energy from incident light that strikes the CMOS sensor.

One disadvantage in the prior art CMOS sensor devices that switch between energy collection and imaging modes is that the camera is unable to produce images while the CMOS sensor is collecting energy. If the camera does not have sufficient battery capacity or access to another energy source, then the camera may be unable to generate images for relatively long periods of time while the CMOS sensor harvests energy. In the sensor embodiments that include fixed arrays of photovoltaic sensors, both the maximum imaging resolution and the maximum energy collection capabilities of the sensor are restricted because the two-dimensional surface of the sensor dedicates a fraction of the sensor area to photovoltaic energy collector elements and another fraction of the sensor area to image sensing elements. Still other embodiments use two separate chips where one chip is a dedicated CMOS sensor and another chip is a dedicated energy harvesting device, although the two-chip devices are more expensive and complex than single-chip configurations. In many cameras, the maximum size of the CMOS sensor is limited, which means that a very large CMOS sensor incorporating a large number of sensing elements and a large array of photovoltaic sensors is impractical. Consequently, improvements to CMOS devices that would enable simultaneous collection of energy and the generation of image data using a single CMOS device would be beneficial.

The following documents disclose further technological background information for the present invention:
US 2012/319225 A1 (KIM MOON J [US]) 20 December 2012
   (2012-12-20)
US 2010-0219789 A1 (AMINE BERMAK et al.) 02 September 2010
US 2010-0270459 A1 (CARLOS J.R.P. AUGUSTO) 28 October 2010
US 2012/319225 A1 describes a system that employs a sequential or parallel read-out of columns of PV cells. As illustrated in its FIG. 5A-5D, this document teaches for a so-called PV and imaging cell array 500A of D1 that any one column of the system will be in a first mode, while another column cell will be in a second mode.
US 2010/0219789 A1 describes that a sensor system determines a need to change the operating mode of a sensing element based on the occurrence of a predetermined threshold using an asynchronous readout technique, where highly illuminated pixels charge up quickly and the output signals are read out from these pixels first.
US 20100270459 A1 relates to a photo-current mode of operation for Full Frame CCDs that is suitable for electrical power generation when not in operation for image sensing.

### SUMMARY

The object of the present invention is to provide a semiconductor sensor and energy collector device which can be configured flexibly to collect energy and simultaneously generate image data in a camera or other imaging device. For a solution of this object the device of claim 1 includes an array of pixels that are divided into super pixel groups that include a predetermined number of pixels. In a first operating mode, a first set of the pixels in each super pixel operates as a photovoltaic energy collector while a second set of the pixels in each super pixel group operate as image data sensors. In a second operating mode, at least one pixel in each super pixel group that operates as a photovoltaic energy collector in the first operating mode operates as an additional image data sensor.

A CMOS image sensor device can simultaneously perform imaging and energy harvesting, which is achieved by using some pixels for imaging, and the rest of pixels for energy harvesting. In order to keep the array structure of the device, the device includes super pixels that group together arrays of individual pixels for simplified control. A super pixel is a small array of pixels, which is the single building block of an imager arrays. Any reconfiguration of the array is done at the super pixel level, which enables simplified control of a larger number of pixels. Further advantageous embodiments and improvements of the invention are listed in the dependent claims. Aspects of the invention which contribute to the understanding of the invention are listed below.

In one aspect, an image sensing and energy collecting device has been developed. The device includes a complementary metal oxide (CMOS) sensor and a controller operatively connected to the CMOS sensor. The CMOS sensor incudes a plurality of pixels arranged in an array, each pixel in the plurality of pixels including a photodiode configured to generate electricity in response to light striking the CMOS sensor and each pixel being configurable to generate a sensor signal from the photodiode in a first operating mode and collect electrical power from the photodiode in a second operating mode. In another aspect, the controller is configured to operate a first portion of the plurality of pixels in the first operating mode to generate sensor signals from the first portion of the plurality of pixels, and operate a second portion of the plurality of pixels in the second operating mode to generate electricity from the second portion of the plurality of pixels concurrently to the operation of the first portion of the plurality of pixels in the first mode.

### BRIEF DESCRIPTION OF THE DRAWINGS

FIG. 1 is a diagram depicting one embodiment of a semiconductor device that is reconfigurable for simultaneous operation as an image sensor and photovoltaic energy collector.
FIG. 2 is a diagram of another embodiment of a semiconductor device that is reconfigurable for simultaneous operation as an image sensor and photovoltaic energy collector.
FIG. 3 is a schematic diagram of a camera that incorporates the semiconductor devices of FIG. 1 or FIG. 2.
FIG. 4 is a schematic diagram of a pixel sensor circuit in a semiconductor device in a first configuration to operate as an image sensing element.
FIG. 5 is a schematic diagram of the pixel sensor circuit of FIG. 4 in a second configuration to operate as a photovoltaic energy collector.

### DETAILED DESCRIPTION

For the purposes of promoting an understanding of the principles of the embodiments disclosed herein, reference is now be made to the drawings and descriptions in the following written specification. No limitation to the scope of the subject matter is intended by the references. The present disclosure also includes any alterations and modifications to the illustrated embodiments and includes further applications of the principles of the disclosed embodiments as would normally occur to one skilled in the art to which this disclosure pertains.

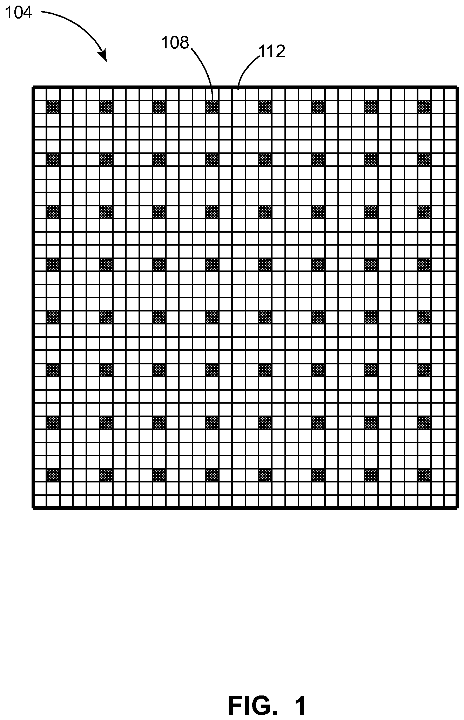

FIG. 1 depicts a semiconductor device 104 that is configured for simultaneous operation as an image sensing device and as a photovoltaic energy collecting device. The device 104 is formed with a two-dimensional array of individual complementary metal oxide semiconductor (CMOS) elements that are referred to as "pixels". In some embodiments, the device 104 is formed from a monolithic silicon wafer and the CMOS pixels are formed using lithographic semiconductor fabrication processes. The illustrative embodiment of FIG. 1 depicts the device 104 with 1,024 pixels, but alternative embodiments can include a smaller or larger number of pixels including embodiments that have multiple millions of pixels ("megapixels") or even billions of pixels ("gigapixels").

During operation of the device 104, a digital control device is operatively connected to the pixels and sends command signals to the pixels to select an operating mode of each pixel for either operation as a CMOS image sensing element or operation as a photovoltaic energy collecting element. In the CMOS image sensing mode, a first region in each CMOS element acts as a photo-detector (e.g. a photo-detector diode) that generates a signal in response to incident light. When incorporated in a camera, the incident light typically passes through a lens and possibly one or more mirrors to be focused onto the sensor 104. As is known in the art, the light generates an electrical signal in the CMOS device via the photoelectric effect. A second region on each CMOS element is dedicated to an active amplifier that boosts the electrical signal from the photo-detector for readout by additional circuits such as analog-to-digital converters (ADCs), digital signal processors (DSPs), and other digital image processing devices. A digital camera processes the outputs form a two-dimensional arrangement of image sensing pixels to generate a digital photographic image.

In an energy collection operating mode, the photo-detector area of the pixel generates the electrical signal in response to incident light using the photovoltaic effect that is known to the art. The active amplifier element in each pixel is deactivated when the pixel is operated as a photovoltaic energy collector. The electrical signals from multiple pixels in the device 104 can be combined for the device 104 to operate as a photovoltaic energy collector.

In the embodiment of the device 104, some pixels operate in the image sensing mode while other pixels operate in the photovoltaic energy collector mode simultaneously. In the configuration of FIG. 1, a smaller subset of pixels, such as the pixel 108, operate as image sensors while the remaining pixels, such as pixel 112, operate as photovoltaic energy collectors. While not a requirement, in FIG. 1 the device 104 operates with the image sensing pixels in a staggered two-dimensional arrangement with the image sensing pixels spaced at regular intervals on the surface of the device 104, while the intervening pixels operate as photovoltaic energy collectors. During operation, a controller can switch the operating mode for some or all of the photovoltaic collector pixels to increase the density of the image sensing pixels up to the maximum density of pixels in the device 104. As the density of the pixels in the image sensing mode increases, the device 104 generates digital photographic images with greater resolution that are typically of a higher image quality than lower-resolution images. The controller can also decrease the density of image sensing pixels to reduce the resolution of images that are generated using the device 104 and in some operating modes the controller operates all of the pixels in the device 104 as photovoltaic energy collectors. As the number of pixels that operate in the photovoltaic collection mode increases, the device 104 generates a greater level of output power that can be used to operate other components in a camera or charge a battery, super capacitor, or other energy storage device.

As described above, the device 104 of FIG. 1 enables a controller to set an operating mode for each pixel in the array of pixels individually. Some applications, however, do not require per-pixel level control over the operating modes of pixels, which can require complex control hardware, wiring, and control software in a control device. In the semiconductor device, both the wiring and the logic consume space, which reduces the area of that is available for imager that is dedicated to the photo-detector diode. This reduces the "fill factor" of the imager array, which refers to the relative surface area of each pixel that is dedicated to the photo-detector instead of to control circuitry that do not contribute to image sensing or energy harvesting.

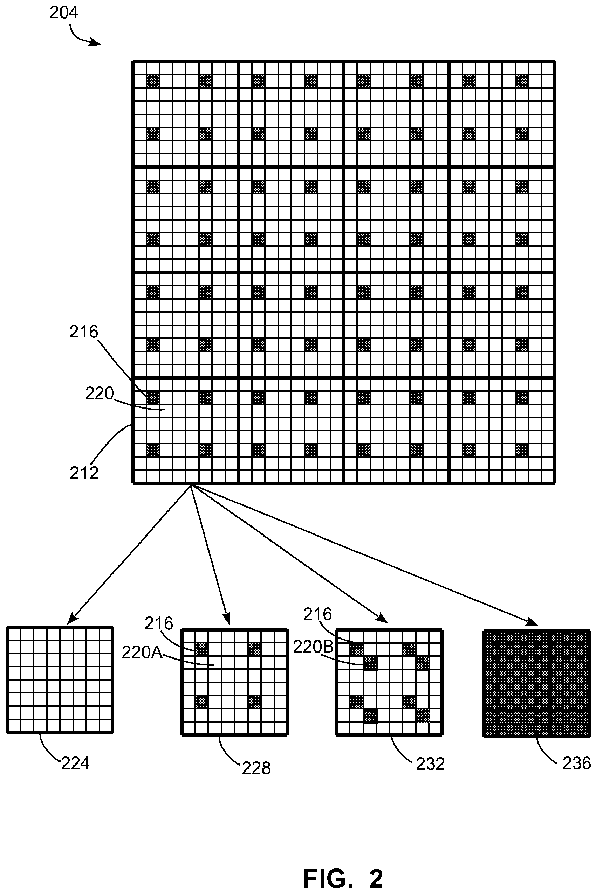

FIG. 2 depicts another embodiment of a semiconductor device 204 that is configured for simultaneous operation as an image sensing device and as a photovoltaic energy collecting device. The device 204 in FIG. 2 also includes a plurality of pixel elements, but in the device 204 the individual pixels are grouped together into 8x8 arrangements of "super pixels," such as the super pixel 212 in the device 204. As used herein, the term "super pixel" refers to a group of individual pixels in the CMOS sensor that are operated in the image sensing and energy collecting modes as group with a finite number of operating mode combinations that is less than the total number of operating mode combinations that are available to the individual pixels within the super pixel group. For example, as depicted in more detail below one embodiment of a super pixel includes a group of pixels that operate in a total of four different operating modes where different combinations of the pixels are configured as image sensing elements or photovoltaic energy collecting elements. Each group of pixels in a super pixel is operated in a comparatively small number of operating modes that reduce the control circuitry requirements in comparison to the individually controllable pixels of the device 104. Alternative embodiments of the device 204 can include super pixels that incorporate larger or smaller arrangements of pixels.

In FIG. 2 each super pixel operates in one of four distinct modes, which are illustrated as super pixel blocks 224, 228, 232, and 236. In mode 224, all of the pixels in the super pixel operate as photovoltaic collectors to maximize the generation of power from the super pixel. The mode 228 includes a low resolution imaging mode where some pixels, such as the pixel 216, operate as imaging sensors while the remaining pixels, including pixel 220A operate as photovoltaic energy collectors. The mode 232 is a higher-resolution imaging mode where additional pixels, such as the pixel 220B, operate as imaging sensors while the remaining pixels operate as photovoltaic collectors. As depicted in the modes 228 and 232, a single pixel 220A and 220B operates as a photovoltaic collector in a first mode and as an image sensor in a second mode, or vice-versa. In the mode 236, all of the pixels in the super pixel operate as image sensor elements to enable operation of the device 204 as an image sensor using all the available pixels in the device. Of course, the configuration of pixels depicted in FIG. 2 is merely illustrative of some pixel configurations. Alternative embodiments can include a smaller number of configurations for simpler control circuitry or a greater number of configurations to enable operation with a greater number of image resolution and energy collection modes. Additionally, alternative embodiments can use different arrangements of image sensing and photovoltaic collection pixels than those depicted in FIG. 2. For example, alternative arrangements of super pixels include groups of one or more rows or columns in the CMOS sensor that are all configured to operate as a single super pixel.

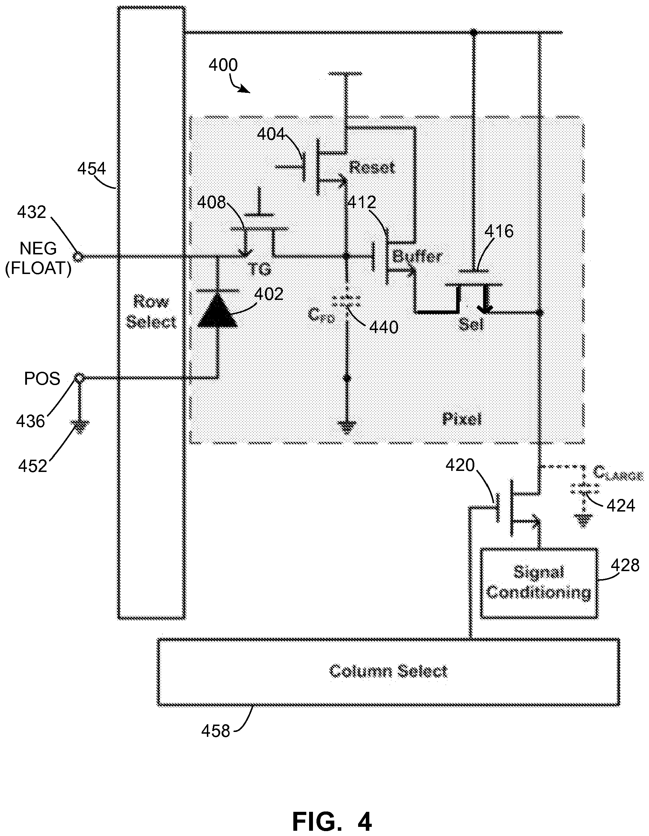

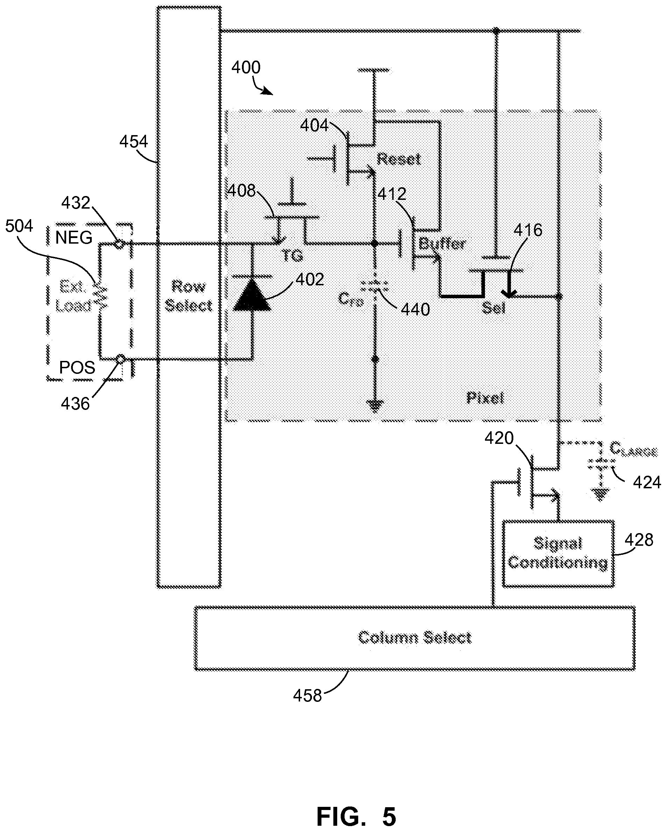

FIG. 4 and FIG. 5 depict two configurations of one of the pixels in the sensors of FIG. 1 and FIG. 2 during both operation of the pixel as an imaging pixel in a CMOS sensor (FIG. 4) and to collect energy (FIG. 5). Referring to FIG. 4, the pixel 400 is a circuit that is configurable to operate both as an imaging pixel in a CMOS image sensor and as a photovoltaic energy collector in two different operating modes. The circuit 400 includes a photodiode 402, reset transistor 404, transfer gate transistor 408, buffer transistor 412, and row select transistor 416. The pixel 400 is connected to other elements in a larger array of CMOS pixels including the row select logic 454, column select logic 458, bit line select transistor 420, bit line capacitor 424, and signal conditioning circuitry 428.

The pixel 400 includes a photodiode 402, reset transistor 404, transfer gate transistor 408, buffer transistor 412, and row select transistor 416. In the configuration of FIG. 4, the anode of the photodiode 402 is not connected to an external capacitor 440. Instead, the cathode of the photodiode 402 is connected to a first output terminal (NEG) 432 and the anode of the cathode 402 is connected to a second output terminal (POS) 436. As described in more detail below, switching electronics in the CMOS sensor connect the terminals 432 and 436 to different external elements to enable the pixel element 400 to operate in both image sensing modes and photovoltaic energy collection modes.

In the circuit 400, the NEG terminal 432 and the POS terminal 436 can be connected to different outputs for energy collection and image sensing operating modes using solid-state switching circuitry that is integrated into the CMOS substrate. In the energy harvesting mode, the POS and NEG terminals act like two terminals of the battery charger and can deliver energy to recharge a battery or charge a capacitor. It can also be used to deliver energy to the load directly.

As the POS and NEG terminals are not fixed to any voltage potential, these terminals can be configured in several different ways. Different photodiodes can be arranged in series, in parallel or a combination of both. Arranging photodiodes in series increases the output voltage, while arranging them in parallel increases their output current.

To deliver energy at certain fixed output voltage, the energy collector converts the energy from one voltage level to another. The output voltage and output impedance of the photodiode array changes depending on the intensity of incident light. This keeps efficiency of the energy harvester varying according to incident light. With the flexibility of arrangement of photodiode configurations, the output impedance of these photodiode arrays is changed for different voltage and current levels.

The reconfiguring capability of the photodiode array also helps maintain high efficiency at variable load current. For example, to deliver higher load currents, the impedance of the photodiode array need to be low. This can be achieved by arranging the photodiodes of the array in parallel. The higher efficiency of the energy harvester leads to lower energy losses thereby reducing the recharging time of the battery or the capacitor.

In the configuration of FIG. 4, the negative terminal 432 is placed in a high-impedance ("float") configuration and the positive terminal 436 is connected to ground 452 to enable the output current from the photodiode 402 to flow to the source of the transfer gate transistor 408. In the configuration of FIG. 4, the output of the photodiode 402 remains within the pixel circuit 400 to charge the capacitor 440. During operation, an external controller (not shown) selects the pixel 400 using the row select logic 454 and column select logic 458 to measure a level of charge in the bit line capacitor 424 that is controlled based on the rate at which the photodiode 402 charges the capacitor 440 to activate the buffer transistor 412. The signal conditioning circuits 428 and other circuits process the measured voltage and convert the measured voltage to a digital value for further digital image processing.

When operating as an image sensing circuit as depicted in FIG. 4, the pixel 400 performs a sampling operation to generate a signal corresponding to a level of light striking the photodiode 402 when the transfer gate transistor 408 is activated and the photodiode 402 charges the capacitor 440 at a rate corresponding to the intensity of light that strikes the photodiode 402 during the sampling period (e.g. higher voltages and a higher charge rate for more intense light, and a lower voltage and charging rate for less intense light). When the capacitor 440 reaches a sufficient voltage level to activate the buffer transistor 412 (e.g. 0.7 V or another suitable voltage level) then current flows through the buffer transistor 412 and the selector transistor 416 to charge the bit line capacitor 424. The bit line capacitor 424 is referred to as C_{LARGE} since the capacitor has sufficient size to store different charge levels across the full range of light intensity levels that the pixel detects during operation. The amount of time that the buffer transistor 412 remains switched on during the predetermined length of the sampling period determines the amount of time that the capacitor 424 accumulates charge. The final level of charge for the capacitor 424 at the end of the sampling period corresponds to the final output level for the pixel after the signal conditioning circuit 428 and other circuits such as analog to digital converters (ADCS) generate a digital output value for the pixel. After a sampling period, the reset transistor 404 drains the sensing capacitor 440, the transistor 420 drains the capacitor 424, and the pixel 400 resets to detect light during a subsequent sampling period.

FIG. 5 depicts a configuration of the circuit 400 of FIG. 4 when the pixel circuit 400 is configured to operate as a photovoltaic energy collector. In the configuration of FIG. 5, the positive terminal 436 and the negative terminal 432 are connected to an external load 504. In one configuration the load 504 is a charging circuit for a battery, super capacitor, or other energy storage device that provides power to different devices in a camera. In other configurations, the load 504 is one or more components in a camera that receive direct power from a CMOS energy collector. In the configuration of FIG. 5, the active components in the circuit 400, including the transistors 404, transfer gate 408, 412, and 416, are all deactivated to enable the current from the photodiode 402 to flow to the load 504 and to reduce power consumption in the CMOS sensor when the pixel 400 is used for energy collection instead of image data generation. As described in more detail below, in a digital camera the load can be other components within the camera or a battery in the camera that receives a charge current from one

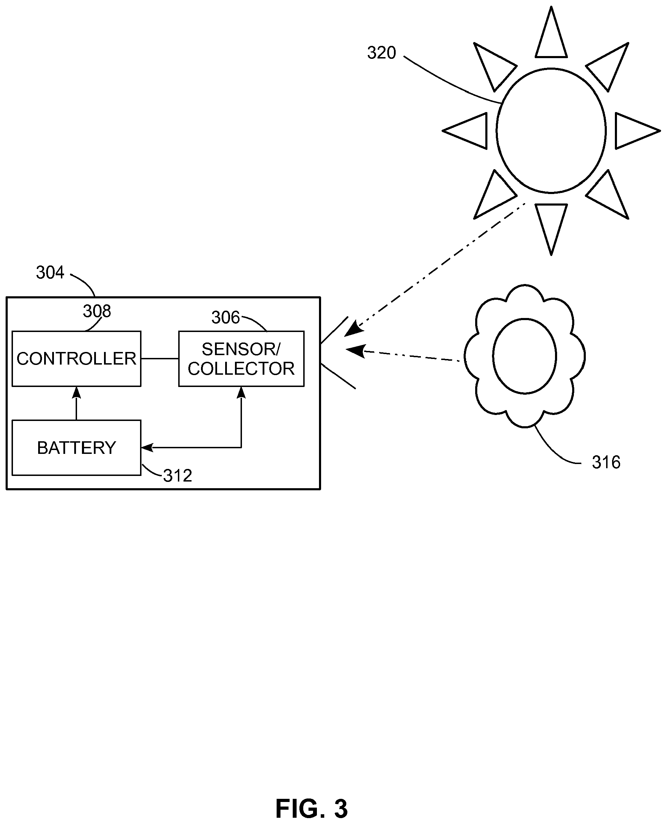

FIG. 3 depicts a camera 304 that incorporates the device 104 of FIG. 1 or the device 204 of FIG. 2. The camera 304 operates as both an image sensing device and an energy collecting device. The camera 304 includes the image sensor and photovoltaic power collector (sensor/collector) device 306, a controller 308, and a battery 312. The device 306 can be either of the device 104 from FIG. 1, the device 204 from FIG. 2, or another embodiment of the semiconductor device that operates as an imaging device and photovoltaic power collector simultaneously. The controller 308 is a control device that incorporates analog and digital control circuitry to operate the device 306. In some embodiments, the controller 308 is implemented using CMOS digital logic circuits that are physically integrated with the semiconductor device 306. In other embodiments, the controller 308 is a discrete control device that is operatively connected to the device 306 via traces on a printed circuit board (PCB) or other suitable connection.

During operation, the controller 308 operates switching elements in the pixels or super pixels within the CMOS sensor to operate pixels in either the image sensing mode as depicted by FIG. 4 or the energy collection mode as depicted in FIG. 5. The controller 308 can also change the operating modes of pixels and super pixels at different times based on the imaging or energy collecting requirements for operation of the camera. The switching elements connect the outputs 432 and 436 to the high-impedance floating and ground configuration of FIG. 4 to direct the output of the photodiode to the bit line capacitor 424 where the signal conditioning circuit 428 measures the voltage of the bit line capacitor 424 and perform additional signal processing to produce digital data from the pixel. For energy harvesting, the outputs 432 and 436 connect the photodiode 402 to the load, which is a charging circuit that provides energy from the pixel 400 and other pixels in the sensor to the battery 312. As described above, in some embodiments the controller 308 is directly connected to switching circuits for each pixel in the CMOS sensor to control the operating mode of each pixel element, while in the super pixel embodiment of FIG. 2 a simplified set of switching electronics controls the operation of large groups of individual pixels in a reduced number of operating modes ranging from full sensing to full energy production modes. For example, in some super pixel configurations, the controller 312 generates three different signals, such as a two-bit binary output, to operate an entire super pixel in either a full energy collection mode, a full sensor mode, or in two intermediate modes in which two different groups of pixels operate as energy collectors and image sensors based on a predetermined configuration of the super pixel, such as the configurations 228 and 232 of FIG. 2. Of course, different super pixel and controller configurations operate the super pixels in a different number of intermediate modes with varying arrangements of pixels in both the image sensing and energy collecting operating modes.

The battery 312 provides electrical power to operate the controller 308, sensor 306, and other components in the camera 304 such as focusing devices, shutters, pan and tilt servos, and the like. The battery 312 is a rechargeable energy storage device such as a lithium-ion battery cell or other electrochemical cell. In some embodiments, the battery 312 further comprises a super capacitor or other energy storage device.

During operation, the camera 304 generates digital images of an environment around the camera, such as the object 316 in FIG. 1. In the environment around the camera, one or more light sources 320 provide illumination for the object 316 and provide light that the sensor/collector 306 converts into an electrical charging current to charge the battery 312 and provide power for components in the camera 304. One example of a suitable light source is 320 is the sun, but some artificial light sources also provide sufficient light energy to enable the device 306 to collect useful amounts of energy for operation of the camera 304. In some embodiments, a lens or mirrors in the camera 304 concentrates light from the light source 320 onto the surface of the sensor/collector 306, which enables the photovoltaic collector pixels in the sensor to generate higher levels of power compared to direct un-concentrated light from the same light source 320.

For many applications, the camera 304 operates in a low-power monitoring mode in order to reduce the power consumption from the battery 312. In the low-power monitoring mode, the camera 304 produces reduced resolution images since a large portion of the pixels operate as photovoltaic collectors. As depicted above in FIG. 2, if the device 306 incorporates super pixels, then the controller 308 operates the sensor/collector device 306 in a limited number of modes for different image resolution and energy generation modes in the device 306.

In some operating conditions, the light source 320 provides sufficient energy for the camera 304 to operate solely with the energy provided by the sensor/collector 306. In other operating modes, the sensor/collector 306 provides a portion of the required power while the battery 312 provides the balance of required power to operate the camera 304. The additional power from the sensor/collector 306 prolongs the effective life of the battery 312 between charging cycles and can be useful for cameras that are solely battery operated, or for reduction of energy consumption in cameras that may receive power from an electrical grid or other electrical power source.

It will be appreciated that variants of the above-disclosed and other features and functions, or alternatives thereof, may be desirably combined into many other different systems, applications or methods.

## Claims

1. An image sensing and energy collecting device (204) comprising:
a complementary metal oxide (CMOS) sensor, the CMOS sensor further comprising:
1.1 a plurality of pixels arranged in an array, each pixel in the plurality of pixels including a photodiode configured to generate electricity in response to light striking the CMOS sensor and each pixel being configurable to generate a sensor signal from the photodiode in a first operating mode and collect electrical power from the photodiode in a second operating mode,
wherein the plurality of pixels are operationally divided into a plurality of a super pixels (212), each of the super pixel comprising a portion of the plurality of pixels in the CMOS sensor; and
1.2 a controller operatively connected to the CMOS sensor, the controller being configured to:
1.2.1 operate at least one or more of the plurality of pixels within at least one of a plurality of the super pixel (212) in the first operating mode (236, 228, 232) to generate sensor signals from the all or first portion of the plurality of pixels; and
1.2.2 operate at least one or more of the plurality of pixels within at least one of a plurality of the super pixel (212) in the second operating mode (224, 228, 232) to generate electricity from the all or second portion of the plurality of pixels concurrently to the operation of the first portion of the plurality of pixels in the first mode.

2. The image sensing and energy collecting device of claim 1 further comprising:
a battery connected to the CMOS sensor, the battery receiving a charging current from the plurality of pixels in the CMOS sensor operated in second operating mode in at least one of the plurality of the super pixel (212).

3. The image sensing and energy collecting device of claim 2, the battery being connected to the controller to supply the controller with electrical power.

4. The image sensing and energy collecting device of claim 2, the battery further comprising:
a lithium-ion battery cell.

5. The image sensing and energy collecting device of claim 2, the battery further comprising:
a super capacitor.

6. The image sensing and energy collecting device of claim 1, the controller being further configured to:
operate each pixel in at least one of the plurality of super pixels in the first operating mode to generate electricity from each of the plurality of pixels.

7. The image sensing and energy collecting device of claim 1, the controller being further configured to:
operate each pixel in at least one of the plurality of super pixels in the second operating mode to generate sensor signals from each of the plurality of pixels.

8. The image sensing and energy collecting device of claim 1, at least one pixel in the first portion of the plurality of pixels further comprising:
a ground output connected to an anode of the photodiode;
a high impedance output and a transfer gate connected to a cathode of the photodiode;
a buffer transistor connected to the transfer gate;
a row select transistor connected to the buffer transistor;
a bit select transistor connected to the buffer transistor; and
a signal conditioning circuit connected to the bit select transistor.

9. The image sensing and energy collecting device of claim 1, at least one pixel in the second portion of the plurality of pixels further comprising:
a load connected to an anode and a cathode of the photodiode; and
a transfer gate transistor connected to a cathode of the photodiode, the transfer gate transistor being deactivated during the second operating mode.

10. The image sensing and energy collecting device of claim 1, the controller being further configured to:
change an operating mode of one pixel in the first portion of the plurality of pixels from the first operating mode to the second operating mode.

11. The image sensing and energy collecting device of claim 1, the controller being further configured to:
operate a first super pixel in the plurality of super pixels in the first mode with each pixel within the first super pixel operating in the first mode; and
operate a second super pixel in the plurality of super pixels in the second mode with each pixel within the second super pixel operating in the second mode concurrently to the operation of the first super pixel in the first mode.

12. The image sensing and energy collecting device from claim 11, the controller being further configured to:
change an operating mode of the first super pixel with each pixel within the first super pixel operating in the second mode.

13. The image sensing and energy collecting device of claim 1, the controller being further configured to:
operate a first super pixel in the plurality of super pixels in an intermediate mode with a first predetermined portion of the pixels in the first super pixel operating in the first mode to generate a plurality of sensor signals and a second predetermined portion of the pixels in the first super pixel operating in the second mode to collect electrical power from the second predetermined portion of the pixels.

14. The image sensing and energy collecting device of claim 1 further comprising:
a lens configured to focus light onto the CMOS sensor in a camera.

## Patentansprüche

1. Bilderfassungs- und Energiesammelvorrichtung (204), umfassend:
einen komplementären Metalloxid-(CMOS)-Sensor, wobei der CMOS-Sensor ferner umfasst:
1.1 mehrere Pixel, die in einem Array angeordnet sind, wobei jedes Pixel in den mehreren Pixeln eine Fotodiode beinhaltet, die dazu ausgelegt ist, Elektrizität als Reaktion auf Licht, das auf den CMOS-Sensor auftrifft, zu erzeugen, und jedes Pixel dazu auslegbar ist, ein Sensorsignal von der Fotodiode in einer ersten Betriebsart zu erzeugen und elektrische Energie von der Fotodiode in einer zweiten Betriebsart zu sammeln,
wobei die mehreren Pixel funktionsfähig in mehrere Superpixel (212) unterteilt sind, wobei jedes der Superpixel einen Teil der mehreren Pixel in dem CMOS-Sensor umfasst; und
1.2 eine Steuerung, die funktionsfähig mit dem CMOS-Sensor verbunden ist, wobei die Steuerung dazu ausgelegt ist:
1.2.1 mindestens ein oder mehrere der mehreren Pixel innerhalb mindestens eines der mehreren des Superpixels (212) in der ersten Betriebsart (236, 228, 232) zu betreiben, um Sensorsignale aus dem gesamten oder ersten Teil der mehreren Pixel zu erzeugen; und
1.2.2 mindestens ein oder mehrere der mehreren Pixel innerhalb mindestens eines der mehreren Superpixel (212) in der zweiten Betriebsart (224, 228, 232) zu betreiben, um Elektrizität aus dem gesamten oder zweiten Teil der mehreren Pixel gleichzeitig mit dem Betrieb des ersten Teils der mehreren Pixel in der ersten Betriebsart zu erzeugen.

2. Bilderfassungs- und Energiesammelvorrichtung nach Anspruch 1, ferner umfassend:
eine mit dem CMOS-Sensor verbundene Batterie, wobei die Batterie einen Ladestrom von den mehreren Pixeln in dem CMOS-Sensor empfängt, der in einer zweiten Betriebsart in mindestens einem der mehreren der Superpixel (212) betrieben wird.

3. Bilderfassungs- und Energiesammelvorrichtung nach Anspruch 2, wobei die Batterie mit der Steuerung verbunden ist, um die Steuerung mit elektrischer Leistung zu versorgen.

4. Bilderfassungs- und Energiesammelvorrichtung nach Anspruch 2, wobei die Batterie ferner umfasst:
eine Lithium-Ionen-Batteriezelle.

5. Bilderfassungs- und Energiesammelvorrichtung nach Anspruch 2, wobei die Batterie ferner umfasst:
einen Superkondensator.

6. Bilderfassungs- und Energiesammelvorrichtung nach Anspruch 1, wobei die Steuerung ferner dazu ausgelegt ist:
jedes Pixel in mindestens einem der mehreren Superpixel in der ersten Betriebsart zu betreiben, um aus jedem der mehreren Pixel Elektrizität zu erzeugen.

7. Bilderfassungs- und Energiesammelvorrichtung nach Anspruch 1, wobei die Steuerung ferner dazu ausgelegt ist:
jedes Pixel in mindestens einem der mehreren Superpixel in der zweiten Betriebszustand zu betreiben, um aus jedem der mehreren Pixel Sensorsignale von jedem der mehreren Pixel zu erzeugen.

8. Bilderfassungs- und Energiesammelvorrichtung nach Anspruch 1, wobei mindestens ein Pixel im ersten Teil der mehreren Pixel ferner umfasst:
einen Masseausgang, der mit einer Anode der Fotodiode verbunden ist;
einen Hochimpedanzausgang und ein Transfergatter, das mit einer Kathode der Fotodiode verbunden ist;
einen Puffertransistor, der mit dem Transfer Gate verbunden ist;
einen Zeilenauswahltransistor, der mit dem Puffertransistor verbunden ist;
einen Bitauswahltransistor, der mit dem Puffertransistor verbunden ist; und
eine Signalaufbereitungsschaltung, die mit dem Bitauswahltransistor verbunden ist.

9. Bilderfassungs- und Energiesammelvorrichtung nach Anspruch 1, wobei mindestens ein Pixel im zweiten Teil der mehreren Pixel ferner umfasst:
eine Last, die mit einer Anode und einer Kathode der Fotodiode verbunden ist; und
einen Transfer-Gate-Transistor, der mit einer Kathode der Fotodiode verbunden ist, wobei der Transfer-Gate-Transistor während der zweiten Betriebsart deaktiviert wird.

10. Bilderfassungs- und Energiesammelvorrichtung nach Anspruch 1, wobei die Steuerung ferner dazu ausgelegt ist:
Ändern einer Betriebsart eines Pixels im ersten Teil der mehreren Pixel von der ersten Betriebsart in die zweite Betriebsart.

11. Bilderfassungs- und Energiesammelvorrichtung nach Anspruch 1, wobei die Steuerung ferner dazu ausgelegt ist:
ein erstes Superpixel in den mehreren Superpixeln in der ersten Betriebsart zu betreiben, wobei jedes Pixel in dem ersten Superpixel in der ersten Betriebsart arbeitet; und
ein zweites Superpixel in den mehreren Superpixeln in der zweiten Betriebsart zu betreiben, wobei jedes Pixel innerhalb des zweiten Superpixels in der zweiten Betriebsart gleichzeitig mit dem Betrieb des ersten Superpixels in der ersten Betriebsart arbeitet.

12. Bilderfassungs- und Energiesammelvorrichtung nach Anspruch 11, wobei die Steuerung ferner dazu ausgelegt ist:
eine Betriebsart des ersten Superpixels zu ändern, wobei jedes Pixel innerhalb des ersten Superpixels in der zweiten Betriebsart arbeitet.

13. Bilderfassungs- und Energiesammelvorrichtung nach Anspruch 1, wobei die Steuerung ferner dazu ausgelegt ist:
ein erstes Superpixel in den mehreren Superpixeln in einer Zwischenbetriebsart mit einem ersten vorbestimmten Teil der Pixel in dem ersten Superpixel, das in der ersten Betriebsart arbeitet, um mehrere Sensorsignale zu erzeugen, und einen zweiten vorbestimmten Teil der Pixel in dem ersten Superpixel, das in der zweiten Betriebsart arbeitet, um elektrische Energie aus dem zweiten vorbestimmten Teil der Pixel zu sammeln, zu betreiben.

14. Bilderfassungs- und Energiesammelvorrichtung nach Anspruch 1, ferner umfassend:
ein Objektiv, das dazu ausgelegt ist, Licht auf den CMOS-Sensor in einer Kamera zu fokussieren.

## Revendications

1. Dispositif capteur d'images et de collecte d'énergie (204) comprenant :
un capteur à oxyde-métal complémentaire (CMOS), le capteur CMOS comprenant en outre :
1.1 une pluralité de pixels agencés dans un groupement, chaque pixel dans la pluralité de pixels incluant une photodiode configurée pour générer de l'électricité en réaction au fait que de la lumière frappe le capteur CMOS et chaque pixel étant configurable pour générer un signal de capteur en provenance de la photodiode dans un premier mode d'exploitation et pour collecter de l'énergie électrique en provenance de la photodiode dans un deuxième mode d'exploitation,
dans lequel la pluralité de pixels sont divisés de manière opérationnelle en une pluralité de super pixels (212), chacun des super pixels comprenant une partie de la pluralité de pixels dans le capteur CMOS ; et
1.2 un dispositif de commande connecté de manière opérationnelle au capteur CMOS, le dispositif de commande étant configuré pour :
1.2.1 exploiter au moins un ou plusieurs pixels de la pluralité de pixels au sein d'au moins un super pixel d'une pluralité des super pixels (212) dans le premier mode d'exploitation (236, 228, 232) afin de générer des signaux de capteur en provenance de la totalité ou d'une première partie de pixels de la pluralité de pixels ; et
1.2.2 exploiter au moins un ou plusieurs pixels de la pluralité de pixels au sein d'au moins un super pixel d'une pluralité des super pixels (212) dans le deuxième mode d'exploitation (224, 228, 232) afin de générer de l'électricité en provenance de la totalité ou d'une deuxième partie de pixels de la pluralité de pixels concurremment à l'exploitation de la première partie de pixels de la pluralité de pixels dans le premier mode.

2. Dispositif capteur d'images et de collecte d'énergie de la revendication 1 comprenant en outre :
une batterie connectée au capteur CMOS, la batterie recevant un courant de charge en provenance de la pluralité de pixels dans le capteur CMOS exploité dans le deuxième mode d'exploitation dans au moins un super pixel de la pluralité des super pixels (212).

3. Dispositif capteur d'images et de collecte d'énergie de la revendication 2, la batterie étant connectée au dispositif de commande pour alimenter le dispositif de commande en énergie électrique.

4. Dispositif capteur d'images et de collecte d'énergie de la revendication 2, la batterie comprenant en outre :
une cellule de batterie lithium-ion.

5. Dispositif capteur d'images et de collecte d'énergie de la revendication 2, la batterie comprenant en outre :
un super condensateur.

6. Dispositif capteur d'images et de collecte d'énergie de la revendication 1, le dispositif de commande étant configuré en outre pour :
exploiter chaque pixel dans au moins un super pixel de la pluralité de super pixels dans le premier mode d'exploitation afin de générer de l'électricité en provenance de chaque pixel de la pluralité de pixels.

7. Dispositif capteur d'images et de collecte d'énergie de la revendication 1, le dispositif de commande étant configuré en outre pour :
exploiter chaque pixel dans au moins un super pixel de la pluralité de super pixels dans le deuxième mode d'exploitation afin de générer des signaux de capteur en provenance de chaque pixel de la pluralité de pixels.

8. Dispositif capteur d'images et de collecte d'énergie de la revendication 1, au moins un pixel dans la première partie de la pluralité de pixels comprenant en outre :
une sortie de masse connectée à une anode de la photodiode ;
une sortie à haute impédance et une grille de transfert connectées à une cathode de la photodiode ;
un transistor tampon connecté à la grille de transfert ;
un transistor de sélection de rangée connecté au transistor tampon ;
un transistor de sélection de bits connecté au transistor tampon ; et
un circuit de mise en forme de signaux connecté au transistor de sélection de bits.

9. Dispositif capteur d'images et de collecte d'énergie de la revendication 1, au moins un pixel dans la deuxième partie de la pluralité de pixels comprenant en outre :
une charge connectée à une anode et à une cathode de la photodiode ; et
un transistor à grille de transfert connecté à une cathode de la photodiode, le transistor à grille de transfert étant désactivé durant le deuxième mode d'exploitation.

10. Dispositif capteur d'images et de collecte d'énergie de la revendication 1, le dispositif de commande étant configuré en outre pour :
changer un mode d'exploitation d'un pixel dans la première partie de la pluralité de pixels depuis le premier mode d'exploitation vers le deuxième mode d'exploitation.

11. Dispositif capteur d'images et de collecte d'énergie de la revendication 1, le dispositif de commande étant configuré en outre pour :
exploiter un premier super pixel dans la pluralité de super pixels dans le premier mode avec chaque pixel au sein du premier super pixel fonctionnant dans le premier mode ; et
exploiter un deuxième super pixel dans la pluralité de super pixels dans le deuxième mode avec chaque pixel au sein du deuxième super pixel fonctionnant dans le deuxième mode concurremment à l'exploitation du premier super pixel dans le premier mode.

12. Dispositif capteur d'images et de collecte d'énergie provenant de la revendication 11, le dispositif de commande étant configuré en outre pour :
changer un mode d'exploitation du premier super pixel avec chaque pixel au sein du premier super pixel fonctionnant dans le deuxième mode.

13. Dispositif capteur d'images et de collecte d'énergie de la revendication 1, le dispositif de commande étant configuré en outre pour :
exploiter un premier super pixel dans la pluralité de super pixels dans un mode intermédiaire avec une première partie prédéterminée des pixels dans le premier super pixel fonctionnant dans le premier mode afin de générer une pluralité de signaux de capteur et une deuxième partie prédéterminée des pixels dans le premier super pixel fonctionnant dans le deuxième mode afin de collecter de l'énergie électrique en provenance de la deuxième partie prédéterminée des pixels.

14. Dispositif capteur d'images et de collecte d'énergie de la revendication 1 comprenant en outre :
une lentille configurée pour focaliser la lumière sur le capteur CMOS dans une caméra.
